# EUROPEAN PATENT SPECIFICATION

(11) **EP 2 562 808 B1**
(45) Date of publication and mention of the grant of the patent: **03.08.2016**
(21) Application number: 11178774.3
(22) Date of filing: 25.08.2011
(51) Int. Cl.: H01L 23/427

(54) **Cooled electrical assembly**
Gekühlte elektrische Baugruppe
Ensemble électrique refroidi

(43) Date of publication of application: 27.02.2013
(73) Proprietor: ABB Technology Oy, 00380 Helsinki (FI)
(72) Inventor: Seväkivi, Pertti, 01830 Lepsämä (FI); Talja, Markku, 04400 Järvenpää (FI)
(74) Representative: Kolster Oy Ab

(56) References cited:
- EP-A1- 0 047 655
- JP-A- 56 100 292
- US-A- 3 834 454
- US-A- 5 283 464

## Description

### FIELD OF THE INVENTION

The present invention relates to a cooled electrical assembly provided with at least one heat pipe.

A known cooled electrical assembly comprises a plurality of heat pipes, each of the heat pipes having a tubular evaporator portion, a tubular condenser portion, and a ceramic insulation element between the tubular evaporator portion and the tubular condenser portion, the ceramic insulation element having a form of an annular ring.

One of the disadvantages associated with the above arrangement is its complex structure. In practise a cooling power of the assembly is directly proportional to a number of heat pipes. The more cooling power is needed the more heat pipes the assembly comprises.

Examples of known cooled electrical assemblies are described in publications US 3 834 454, US 5 283 464, JP 56100 292 and EP 0 047 655.

### BRIEF DESCRIPTION OF THE INVENTION

An object of the present invention is to provide a cooled electrical assembly so as to alleviate the above disadvantage. The object of the invention is achieved by a cooled electrical assembly which is characterized by what is stated in the independent claim 1. The preferred embodiments of the invention are disclosed in the dependent claims.

The invention is based on the idea of forming both an evaporator portion and a condenser portion of each heat pipe as flat portions.

An advantage of the cooled electrical assembly of the invention is its simple structure. A further advantage is that due to the flat form of the condenser portion of each heat pipe a heat transfer area between the condenser portion and heat sink means is large. Also, modifying the heat transfer area due to requirements of different embodiments is easy since it is not necessary to change the number of heat pipes but the flat condenser portion of each heat pipe can be dimensioned to meet required cooling power.

### BRIEF DESCRIPTION OF THE DRAWINGS

In the following the invention will be described in greater detail by means of preferred embodiments with reference to the attached drawings, in which
Figure 1 shows a principle of a cooled electrical assembly according to the invention utilizing planar insulation layers;
Figure 2 shows a circuit diagram of a three phase converter bridge comprising the cooled electrical assembly of Figure 1;
Figure 3 shows a cross section of the three phase converter bridge according to Figure 2; and
Figure 4 shows a principle of a cooled electrical assembly according to the invention utilizing annular insulation elements.

### DETAILED DESCRIPTION OF THE INVENTION

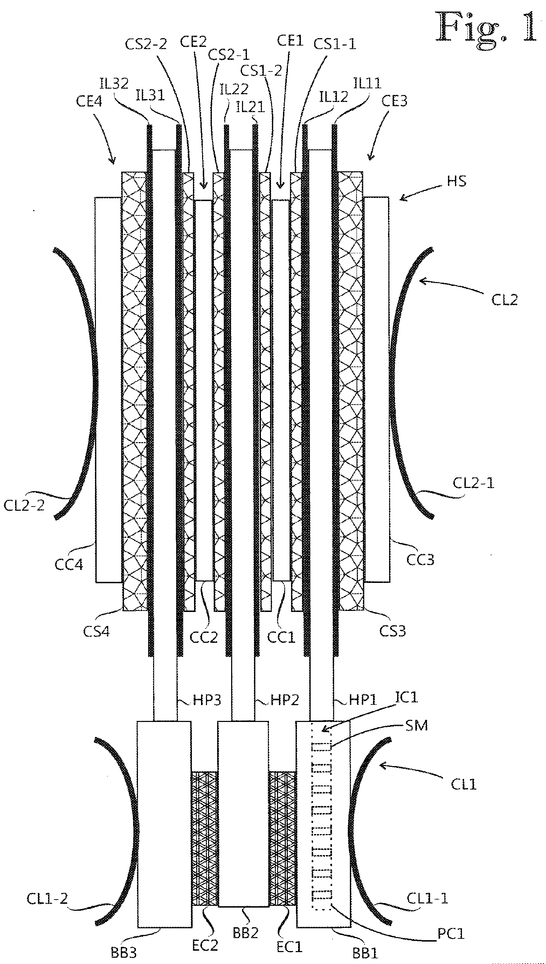

Figure 1 shows a cooled electrical assembly comprising bus bar means, electrical component means, heat pipe means, heat sink means HS, electrical insulation means, first clamping means CL1 and second clamping means CL2. The bus bar means includes a first bus bar BB1, a second bus bar BB2 and a third bus bar BB3. The electrical component means includes a first electrical component EC1 connected between the first bus bar BB1 and the second bus bar BB2, and a second electrical component EC2 connected between the second bus bar BB2 and the third bus bar BB3. The heat pipe means is adapted for cooling the bus bar means and the electrical component means. The heat pipe means includes a heat pipe for each bus bar of the bus bar means. The heat pipe means includes a first heat pipe HP1 for the first bus bar BB1, a second heat pipe HP2 for the second bus bar BB2, and a third heat pipe HP3 for the third bus bar BB3.

An evaporator portion of each of the heat pipes is heat conductively connected to a corresponding bus bar by an integral connection such as brazing. An evaporator portion of the first heat pipe HP1 is heat conductively connected to the first bus bar BB1. An evaporator portion of the second heat pipe HP2 is heat conductively connected to the second bus bar BB2. An evaporator portion of the third heat pipe HP3 is heat conductively connected to the third bus bar BB3. Both the evaporator portion and the condenser portion of each of the heat pipes HP1, HP2 and HP3 are flat portions, a cross section of each of the flat portions having a first dimension and a second dimension perpendicular to the first dimension, the second dimension being substantially greater than the first dimension, the cross section plane being perpendicular to flowing directions of working fluid of corresponding heat pipe.

Each of the heat pipes HP1, HP2 and HP3 is a substantially planar heat pipe such that both the evaporator portion and the condenser portion of each of the heat pipes are located substantially on a same plane. Each of the evaporator portions and each of the condenser portions has a centre plane. In Figure 1 direction of view is parallel to centre planes of the evaporator portions and the condenser portions of each of the heat pipes HP1, HP2 and HP3, the direction of view further being perpendicular to flowing directions of working fluids in the heat pipes HP1, HP2 and HP3.

The heat sink means HS is heat conductively connected to the flat condenser portion of each of the heat pipes HP1, HP2 and HP3. The heat sink means HS may be interpreted as a secondary cooling circuit while the heat pipe means is a primary cooling circuit. An evaporator portion of each of the heats pipes HP1, HP2 and HP3 is electrically insulated from the heat sink means HS by the electrical insulation means.

Both the first electrical component EC1 and the second electrical component EC2 are press-pack components each having two substantially planar terminals located on opposite sides of the electrical component and being substantially parallel to each other. The planar terminals of each of the electrical components EC1 and EC2 are connected electrically conductively to adjacent bus bars.

The first bus bar BB1 comprises a first terminal surface connected to a first terminal of the first electrical component EC1. The second bus bar BB2 comprises a first terminal surface connected to a second terminal of the first electrical component EC1, and a second terminal surface connected to a first terminal of the second electrical component EC2. The third bus bar BB3 comprises a first terminal surface connected to the second terminal of the second electrical component EC2. Each of the terminal surfaces is a smooth machined surface adapted to maximize heat conduction between the terminal surface and the corresponding terminal of the adjacent electrical component. Each of the bus bars of the bus bar means may be manufactured from copper or aluminium, for example.

The first clamping means CL1 is adapted to improve both electrical conductivity and thermal conductivity between each electrical component of the electrical component means and adjacent bus bar of the bus bar means by pressing each electrical component of the electrical component means against adjacent bus bar of the bus bar means. The first clamping means CL1 comprises a first leaf spring element CL1-1 for pressing the first bus bar BB1 towards the first electrical component EC1, and a second leaf spring element CL1-2 for pressing the third bus bar BB3 towards the second electrical component EC2.

The heat sink means HS comprises a liquid cooled heat exchanger having a first coolant element CE1 and a second coolant element CE2. The liquid cooled heat exchanger is stacked with the heat pipe means such that the first coolant element CE1 is clamped between first heat pipe HP1 and the second heat pipe HP2, and the second coolant element CE2 is clamped between the second heat pipe HP2 and the third heat pipe HP3.

The liquid cooled heat exchanger further comprises a third coolant element CE3 and a fourth coolant element CE4. The third coolant element CE3 is located adjacent the first heat pipe HP1, on opposite side of the first heat pipe HP1 relative to the first coolant element CE1. The fourth coolant element CE4 is located adjacent the third heat pipe HP3, on opposite side of the third heat pipe HP3 relative to the second coolant element CE2.

Each coolant element of the liquid cooled heat exchanger comprises a coolant channel member comprising at least one coolant channel for cooling liquid flow. The first coolant element CE1 comprises a first coolant channel member CC1, the second coolant element CE2 comprises a second coolant channel member CC2, the third coolant element CE3 comprises a third coolant channel member CC3, and the fourth coolant element CE4 comprises a fourth coolant channel member CC4.

Each coolant element of the liquid cooled heat exchanger further comprises a contact surface member for each adjacent heat pipe. The first coolant element CE1 comprises a contact surface element CS1-1 adjacent the first heat pipe HP1, and a contact surface element CS1-2 adjacent the second heat pipe HP2. The second coolant element CE2 comprises a contact surface element CS2-1 adjacent the second heat pipe HP2, and a contact surface element CS2-2 adjacent the third heat pipe HP3. The third coolant element CE3 comprises a contact surface element CS3 adjacent the first heat pipe HP1. The fourth coolant element CE4 comprises a contact surface element CS4 adjacent the third heat pipe HP3.

Each contact surface member is integrally connected to corresponding coolant channel member. The integral connection may comprise brazing.

Each contact surface member has a smooth machined surface for heat conductive connection with an adjacent heat pipe. The smooth machined surface is adapted to maximize heat conduction between the contact surface member and the adjacent heat pipe.

The electrical insulation means comprises an insulation layer between a condenser portion of each heat pipe and an adjacent coolant element. Each insulation layer is adapted to electrically insulate the adjacent condenser portion and coolant element. The electrical insulation means comprises an insulation layer IL11 between the condenser portion of the first heat pipe HP1 and the third coolant element CE3, an insulation layer IL12 between the condenser portion of the first heat pipe HP1 and the first coolant element CE1, an insulation layer IL21 between the condenser portion of the second heat pipe HP2 and the first coolant element CE1, an insulation layer IL22 between the condenser portion of the second heat pipe HP2 and the second coolant element CE2, an insulation layer IL31 between the condenser portion of the third heat pipe HP3 and the second coolant element CE2, and an insulation layer IL32 between the condenser portion of the third heat pipe HP3 and the fourth coolant element CE4.

Each insulation layer IL11 - IL32 is a substantially planar layer comprising an aluminium oxide sheet. In alternative embodiments the insulation layers may comprise other types of insulation sheets.

The second clamping means CL2 clamps the liquid cooled heat exchanger and the heat pipe means together. The second clamping means CL2 is thereby adapted to improve heat conduction between the liquid cooled heat exchanger and the heat pipe means. The second clamping means CL2 comprises a first leaf spring element CL2-1 for pressing the third coolant element CE3 towards the condenser portion of the first heat pipe HP1, and a second leaf spring element CL2-2 for pressing the fourth coolant element CE4 towards the condenser portion of the third heat pipe HP3.

The first clamping means and the second clamping means may comprise one or more leaf springs. Alternatively or additionally the first clamping means and the second clamping means may comprise one or more elastic elements of different type such as one or more coil springs.

In an alternative embodiment a cooled electrical assembly comprises first clamping means but not second clamping means. In another alternative a cooled electrical assembly comprises second clamping means but not first clamping means. It is also possible to construct an embodiment comprising neither first clamping means nor second clamping means.

The evaporator portion of each of the heat pipes HP1, HP2 and HP3 comprise a cell pipe structure having an internal cavity provided with a plurality of support members adapted to reduce deformation of the internal cavity of the evaporator portion induced by forces substantially perpendicular to a centre plane of the evaporator portion. In Figure 1 the first heat pipe HP1 is shown partially as a sectional view in order to depict a first internal cavity IC1 inside the evaporator portion of the first heat pipe HP1 as well as a plurality of support members SM in the first internal cavity IC1.

The condenser portion of each of the heat pipes HP1, HP2 and HP3 comprise a cell pipe structure having an internal cavity provided with a plurality of support members adapted to reduce deformation of the internal cavity of the condenser portion induced by forces substantially perpendicular to a centre plane of the condenser portion. The internal cavities of the condenser portions are not depicted in the Figures.

The internal cavities of the evaporator portion and the condenser portion of the heat pipes accommodate working fluid of the heat pipes. The support members inside the internal cavities are arranged such that the support members do not prevent adequate flow of the working fluid. Operating principle of a heat pipe is commonly known and therefore it is not dealt with in detail herein.

Each of the bus bars BB1, BB2 and BB3 is a hollow bus bar comprising an internal heat pipe cavity. The internal heat pipe cavity of each of the bus bars accommodates an evaporator portion of a corresponding heat pipe.

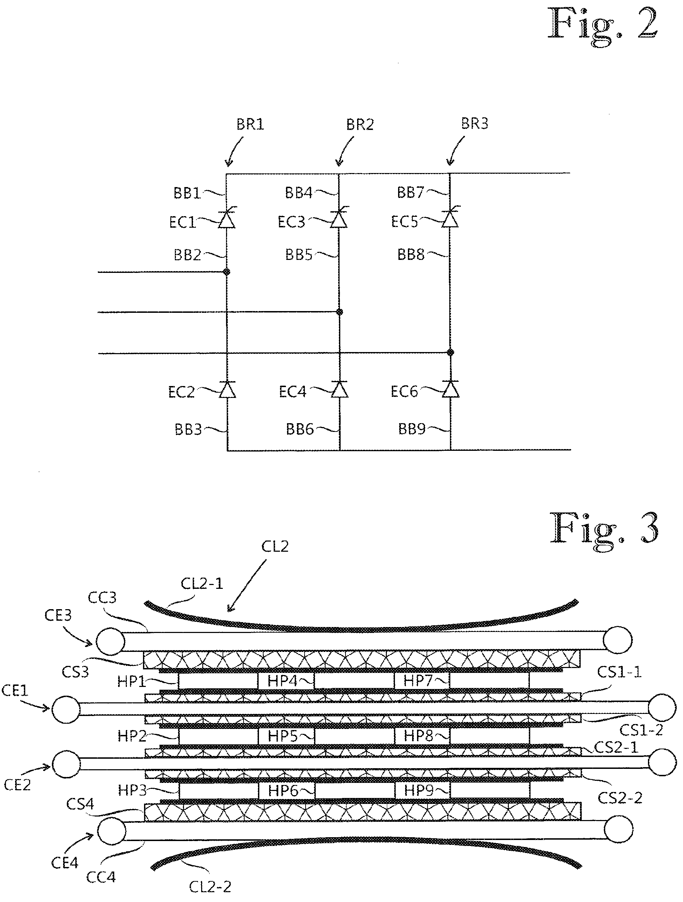

Figure 2 shows a circuit diagram of a three phase converter bridge comprising a first branch BR1, a second branch BR2 and a third BR3, each one of the branches including corresponding components as the cooled electrical assembly of Figure 1. The branches BR1, BR2 and BR3 are connected in parallel.

The first branch BR1 comprises a first bus bar BB1, a second bus bar BB2, a third bus bar BB3, a first electrical component EC1 and a second electrical component EC2. The second branch BR2 comprises a fourth bus bar BB4, a fifth bus bar BB5, a sixth bus bar BB3, a third electrical component EC3 and a fourth electrical component EC4. The third branch BR3 comprises a seventh bus bar BB7, an eight bus bar BB8, a ninth bus bar BB9, a fifth electrical component EC5 and a sixth electrical component EC6. Since Figure 2 is a circuit diagram heat pipe means, heat sink means, electrical insulation means, first clamping means and second clamping means are omitted.

In the three phase converter bridge of Figure 2 the first bus bar BB1, the fourth bus bar BB4 and the seventh bus bar BB7 are electrically connected to a positive DC bus bar of the three phase converter bridge. The third bus bar BB3, the sixth bus bar BB6 and the ninth bus bar BB9 are electrically connected to a negative DC bus bar of the three phase converter bridge.

Figure 3 shows a cross section of the three phase converter bridge according to Figure 2. In Figure 3 direction of view is perpendicular to the direction of view in Figure 1. The first heat pipe HP1, the fourth heat pipe HP4 and the seventh heat pipe HP7 are located between the first coolant element CE1 and the third coolant element CE3. The second heat pipe HP2, the fifth heat pipe HP5 and the eight heat pipe HP8 are located between the first coolant element CE1 and the second coolant element CE2. The third heat pipe HP3, the sixth heat pipe HP6 and the ninth heat pipe HP9 are located between the second coolant element CE2 and the fourth coolant element CE4. The stacked structure shown in Figure 3 is very compact.

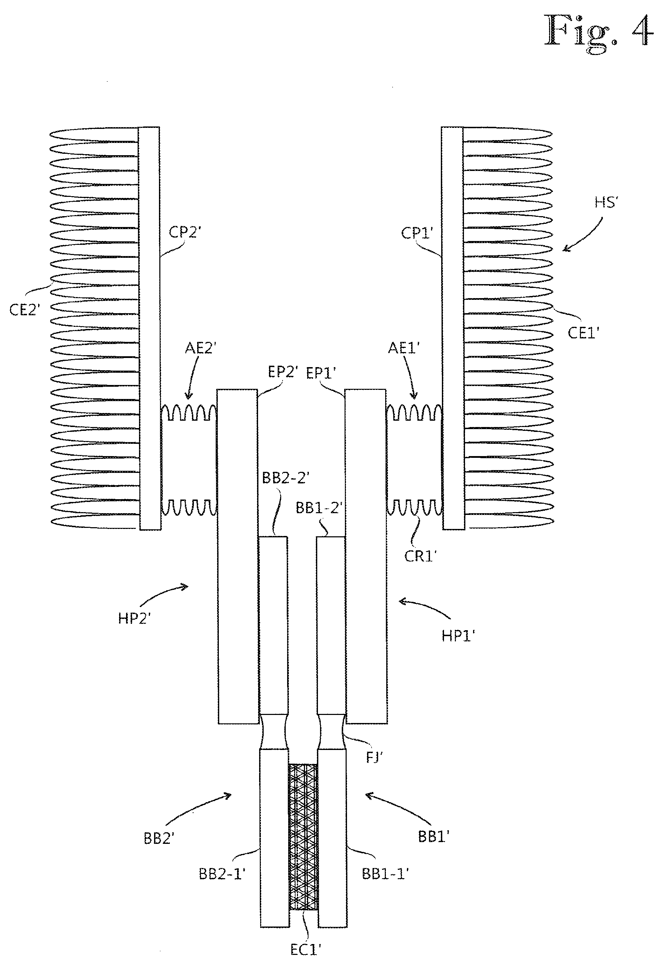

Figure 4 shows a principle of a cooled electrical assembly utilizing ceramic insulation. The cooled electrical assembly comprises bus bar means, electrical component means, heat pipe means, heat sink means HS' and electrical insulation means. The bus bar means include a first bus bar BB1' and a second bus bar BB2'. The electrical component means includes a first electrical component EC1' connected between the first bus bar BB1' and the second bus bar BB2'. The heat pipe means includes a first heat pipe HP1' for the first bus bar BB1', and second heat pipe HP2' for the second bus bar BB2'. Evaporator portions and condenser portions of the first heat pipe HP1' and the second heat pipe HP2' are flat portions.

The heat sink means HS' comprises an air cooled heat exchanger having a first coolant element CE1' and a second coolant element CE2'.

The electrical insulation means comprises an annular insulation element AE1' for the first heat pipe HP1', and an annular insulation element AE2' for the second heat pipe HP2'. The annular insulation elements AE1' and AE2' comprise ceramic material. Each of the annular insulation elements comprises an internal working fluid cavity adapted to provide a flowing path for a working fluid of corresponding heat pipe.

The annular insulation element AE1' is located between the evaporator portion EP1' and the condenser portion CP1' of the first heat pipe HP1' for electrically insulating the evaporator portion EP1' from the condenser portion CP1'. The centre axis of the annular insulation element AE1' is perpendicular to the planes of the evaporator portion EP1' and the condenser portion CP1'.

Working fluid inside the first heat pipe HP1' and the second heat pipe HP2' does not form an electrically conductive connection between the evaporator portion and the condenser portion of the heat pipes because of a low pressure of the working fluid. Alternatively or additionally it is possible to choose a working fluid which is an electrically insulating fluid.

The first bus bar BB1' comprises a first bus bar portion BB1-1', a second bus bar portion BB1-2' and a flexible joint FJ' connecting the first bus bar portion BB1-1' and the second bus bar portion BB1-2'. The flexible joint FJ' is adapted to allow a central plane of the first bus bar portion BB1-1' to be divergent with respect to a central plane of the evaporator portion EP1' of the first heat pipe HP1'. In other words the flexible joint FJ' allows an angle between the central plane of the first bus bar portion BB1-1' and the central plane of the evaporator portion EP1' of the first heat pipe HP1'.

The annular insulation element AE1' comprises a corrugated outer surface CR1' adapted to improve electrical insulation between the evaporator portion EP1' and the condenser portion CP1'.

Although features like an annular insulation element and a bus bar with a flexible joint are disclosed in connection with an air cooled embodiment, it is clear that they may be used in liquid cooled embodiments as well. Similarly, features like substantially planar insulation layers, first clamping means and support members may be used in air-cooled embodiments.

It will be obvious to a person skilled in the art that the inventive concept can be implemented in various ways. The invention and its embodiments are not limited to the examples described above but may vary within the scope of the claims.

## Claims

1. A cooled electrical assembly comprising bus bar means including at least a first bus bar (BB1) and a second bus bar (BB2), electrical component means including at least a first electrical component (EC1) connected between the first bus bar (BB1) and the second bus bar (BB2), and heat pipe means for cooling the bus bar means, the heat pipe means including a heat pipe (HP1, HP2, HP3) for each bus bar (BB1, BB2, BB3) of the bus bar means, an evaporator portion of each of the heat pipes (HP1, HP2, HP3) being heat conductively connected to a corresponding bus bar (BB1, BB2, BB3), both the evaporator portion and a condenser portion of each heat pipe (HP1, HP2, HP3) of the heat pipe means being flat portions, the cooled electrical assembly further comprising heat sink means (HS) heat conductively connected to the flat condenser portion of each of the heat pipes, **characterized in that** an evaporator portion of each of the heats pipes is electrically insulated from the heat sink means (HS) by electrical insulation means, and that the electrical insulation means comprises at least one planar insulation layer (IL11 - IL32) between the condenser portion of each heat pipe (HP1, HP2, HP3) of the heat pipe means and the heat sink means (HS).

2. A cooled electrical assembly according to claim 1, **characterized in that** the heat conductive connection between an evaporator portion of each heat pipe (HP1, HP2, HP3) of the heat pipe means and corresponding bus bar (BB1, BB2, BB3) of the bus bar means is an integral connection provided for example by brazing.

3. A cooled electrical assembly according to claim 1 or 2, **characterized in that** each electrical component (EC1, EC2) of the electrical component means is a press-pack component having a first terminal and a second terminal, both the first terminal and the second terminal being planar terminals, the first terminal and the second terminal being located on opposite sides of the electrical component and being parallel to each other.

4. A cooled electrical assembly according to any preceding claim, **characterized in that** each bus bar (BB1, BB2, BB3) of the bus bar means comprises at least one terminal surface, each of the terminal surfaces being connected to a corresponding terminal of an adjacent electrical component (EC1, EC2) and being a machined surface adapted to maximize heat conduction between the terminal surface and the corresponding terminal of the adjacent electrical component (EC1, EC2).

5. A cooled electrical assembly according to any preceding claim, **characterized in that** the evaporator portion of each heat pipe (HP1) of the heat pipe means comprise a cell pipe structure having an internal cavity (IC1) provided with a plurality of support members (SM) adapted to reduce deformation of the internal cavity of the evaporator portion induced by forces perpendicular to a centre plane of the evaporator portion, and the condenser portion of each of the heat pipes comprise a cell pipe structure having an internal cavity provided with a plurality of support members adapted to reduce deformation of the internal cavity of the condenser portion induced by forces perpendicular to a centre plane of the condenser portion.

6. A cooled electrical assembly according to any preceding claim, **characterized in that** the assembly further comprises first clamping means (CL1) adapted to press each electrical component (EC1, EC2) of the electrical component means an against adjacent bus bar (BB1, BB2, BB3) of the bus bar means.

7. A cooled electrical assembly according to any preceding claim, **characterized in that** each heat pipe (HP1, HP2, HP3) of the heat pipe means is a planar heat pipe such that both the evaporator portion and the condenser portion of the heat pipe (HP1, HP2, HP3) are located on a same plane.

8. A cooled electrical assembly according to any preceding claim, **characterized in that** each bus bar (BB1) of the bus bar means is a hollow bus bar comprising an internal heat pipe cavity (PC1), the internal heat pipe cavity (PC1) of the bus bar (BB1) accommodating at least partially an evaporator portion of a corresponding heat pipe (HP1).

9. A cooled electrical assembly according to any preceding claim, **characterized in that** the bus bar means further includes a third bus bar (BB3), the electrical component means further includes a second electrical component (EC2) connected between the second bus bar (BB2) and the third bus bar (BB3), the heat pipe means including a first heat pipe (HP1), a second heat pipe (HP2) and a third heat pipe (HP3), an evaporator portion of the first heat pipe (HP1) being heat conductively connected to the first bus bar (BB1), and the condenser portion of the first heat pipe (HP1) being heat conductively connected to the heat sink means (HS), an evaporator portion of the second heat pipe (HP2) being heat conductively connected to the second bus bar (BB2), and the condenser portion of the second heat pipe (HP2) being heat conductively connected to the heat sink means (HS), an evaporator portion of the third heat pipe (HP3) being heat conductively connected to the third bus bar (BB3), and the condenser portion of the third heat pipe (HP3) being heat conductively connected to the heat sink means (HS).

10. A cooled electrical assembly according to claim 9, **charac**t**erized** in that the heat sink means (HS) comprises a liquid cooled heat exchanger having a first coolant element (CE1) and a second coolant element (CE2), the liquid cooled heat exchanger being stacked with the heat pipe means such that the first coolant element (CE1) is clamped between the first heat pipe (HP1) and the second heat pipe (HP2), and the second coolant element (CE2) is clamped between the second heat pipe (HP2) and the third heat pipe (HP3).

11. A cooled electrical assembly according to claim 10, **characterized in that** the assembly further comprises second clamping means (CL2) for clamping the liquid cooled heat exchanger and the heat pipe means together.

## Patentansprüche

1. Gekühlte elektrische Baugruppe mit Sammelschienenmitteln, die mindestens eine erste Sammelschiene (BB1) und eine zweite Sammelschiene (BB2) umfassen, Elektrokomponentenmitteln, die mindestens eine erste elektrische Komponente (EC1) umfassen, die zwischen die erste Sammelschiene (BB1) und die zweite Sammelschiene (BB2) geschaltet ist, und Wärmerohrmitteln zum Kühlen der Sammeischienenmittel, wobei die Wärmerohrmittel ein Wärmerohr (HP1, HP2, HP3) für jede Sammelschiene (BB1, BB2, BB3) der Sammelschienenmittel aufweisen, wobei ein Verdampferteil eines jeden von den Wärmerohren (HP1, HP2, HP3) wärmeleitend mit einer entsprechenden Sammelschiene (BB1, BB2, BB3) verbunden ist, wobei sowohl der Verdampferteil als auch ein Kondenserteil eines jeden Wärmerohrs (HP1, HP2, HP3) der Wärmerohrmittel flache Teile sind, wobei die gekühlte elektrische Baugruppe ferner Wärmeableitungsmittel (HS) aufweist, die wärmeleitend mit dem flachen Kondenserteil eines jeden der Wärmerohre verbunden sind, **dadurch gekennzeichnet, dass** ein Verdampferteil eines jeden der Wärmerohre durch elektrische Isolationsmittel elektrisch von dem Wärmeableitungsmittel (HS) isoliert ist und dass die elektrischen Isolationsmittel mindestens eine genaue Isolationsschicht (IL11 - IL32) zwischen dem Kondenserteil eines jeden Wärmerohrs (HP1, HP2, HP3) der Wärmerohrmittel und den Wärmeableitungsmitteln (HS) aufweist.

2. Gekühlte elektrische Baugruppe nach Anspruch 1, **dadurch gekennzeichnet, dass** die wärmeleitende Verbindung zwischen einem Verdampferteil eines jeden Wärmerohrs (HP1, HP2, HP3) der Wärmerohrmittel und der entsprechenden Sammelschiene (BB1, BB2, BB3) der Sammelschienenmittel eine stoffschlüssige Verbindung ist, die zum Beispiel durch Löten erzeugt wird.

3. Gekühlte elektrische Baugruppe nach Anspruch 1 oder 2, **dadurch gekennzeichnet, dass** jede elektrische Komponente (EC1, EC2) der Elektrokomponentenmittel eine Pressstapelkomponente ist, die einen ersten Anschluss und einen zweiten Anschluss aufweist, wobei sowohl der erste Anschluss als auch der zweite Anschluss genaue Anschlüsse sind, wobei der erste Anschluss und der zweite Anschluss auf gegenüberliegenden Seiten der elektrischen Komponente angeordnet und parallel zueinander sind.

4. Gekühlte elektrische Baugruppe nach einem der vorhergehenden Ansprüche, **dadurch gekennzeichnet, dass** jede Sammelschiene (BB1, BB2, BB3) der Sammelschienenmittel mindestens eine Anschlussfläche aufweist, wobei jede der Anschlussflächen mit einem entsprechenden Anschluss einer benachbarten elektrischen Komponente (EC1, EC2) verbunden ist und eine bearbeitete Fläche ist, die geeignet ist, die Wärmeleitung zwischen der Anschlussfläche und dem entsprechenden Anschluss der benachbarten elektrischen Komponente (EC1, EC2) zu maximieren.

5. Gekühlte elektrische Baugruppe nach einem der vorhergehenden Ansprüche, **dadurch gekennzeichnet, dass** der Verdampferteil eines jeden Wärmerohrs (HP1) der Wärmerohrmittel eine Zellenrohrstruktur mit einem inneren Hohlraum (IC1) aufweist, der mit mehreren Stützelementen (SM) versehen ist, die geeignet sind, eine Verformung des inneren Hohlraums des Verdampferteils zu verringern, die durch Kräfte senkrecht zu einer Mittelebene des Verdampferteils hervorgerufen wird, und wobei der Kondenserteil eines jeden der Wärmerohre eine Zellenrohrstruktur mit einem inneren Hohlraum aufweist, der mit mehreren Stützelementen versehen ist, die geeignet sind, eine Verformung des inneren Hohlraums des Kondenserteils zu verringern, die durch Kräfte senkrecht zu einer Mittelebene des Kondenserteils hervorgerufen wird.

6. Gekühlte elektrische Baugruppe nach einem der vorhergehenden Ansprüche, **dadurch gekennzeichnet, dass** die Baugruppe ferner Klemmmittel (CL1) aufweist, die geeignet sind, jede elektrische Komponente (EC1, EC2) der Elektrokomponentenmittel gegen eine benachbarte Sammelschiene (BB1, BB2, BB3) der Sammelschienenmittel zu pressen.

7. Gekühlte elektrische Baugruppe nach einem der vorhergehenden Ansprüche, **dadurch gekennzeichnet, dass** jedes Wärmerohr (HP1, HP2, HP3) der Wärmerohrmittel ein genaues Wärmerohr ist, derart dass sowohl der Verdampferteil aus auch der Kondenserteil des Wärmerohrs (HP1, HP2, HP3) auf einer gleichen Ebene angeordnet sind.

8. Gekühlte elektrische Baugruppe nach einem der vorhergehenden Ansprüche, **dadurch gekennzeichnet, dass** jede Sammelschiene (BB1) der Sammelschienenmittel eine hohle Sammelschiene ist, die einen inneren Wärmerohrhohlraum (PC1) aufweist, wobei der innere Wärmerohrhohlraum (PC1) der Sammelschiene (BB1) mindestens teilweise einen Verdampferteil eines entsprechenden Wärmerohrs (HP1) aufnimmt.

9. Gekühlte elektrische Baugruppe nach einem der vorhergehenden Ansprüche, **dadurch gekennzeichnet, dass** die Sammelschienenmittel ferner eine dritte Sammelschiene (BB3) aufweisen, die Elektrokomponentenmittel ferner eine zweite elektrische Komponente (EC2) aufweisen, die zwischen die zweite Sammelschiene (BB2) und die dritte Sammelschiene (BB3) geschaltet ist, wobei die Wärmerohrmittel ein erstes Wärmerohr (HP1), ein zweites Wärmerohr (HP2) und ein drittes Wärmerohr (HP3) aufweisen, wobei ein Verdampferteil des ersten Wärmerohrs (HP1) wärmeleitend mit der ersten Sammelschiene (BB1) verbunden ist und der Kondenserteil des ersten Wärmerohrs (HP1) wärmeleitend mit den Wärmeableitmitteln (HS) verbunden ist, wobei ein Verdampferteil des zweiten Wärmerohrs (HP2) wärmeleitend mit der zweiten Sammelschiene (BB2) verbunden ist und der Kondenserteil des zweiten Wärmerohrs (HP2) wärmeleitend mit den Wärmeableitmitteln (HS) verbunden ist, wobei ein Verdampferteil des dritten Wärmerohrs (HP3) wärmeleitend mit der dritten Sammelschiene (BB3) verbunden ist und der Kondenserteil des dritten Wärmerohrs (HP3) wärmeleitend mit den Wärmeableitmitteln (HS) verbunden ist.

10. Gekühlte elektrische Baugruppe nach Anspruch 9, **dadurch gekennzeichnet, dass** die Wärmeableitmittel (HS) einen flüssigkeitsgekühlten Wärmetauscher mit einem ersten Kühlmittelelement (CE1) und einem zweiten Kühlmittelelement (CE2) aufweisen, wobei der flüssigkeitsgekühlte Wärmeaustauscher derart mit den Wärmerohrmitteln gestapelt ist, dass das erste Kühlmittelelement (CE1) zwischen das erste Wärmerohr (HP1) und das zweite Wärmerohr (HP2) geklemmt ist und das zweite Kühlmittelelement (CE2) zwischen das zweite Wärmerohr (HP2) und das dritte Wärmerohr (HP3) geklemmt ist.

11. Gekühlte elektrische Baugruppe nach Anspruch 10, **dadurch gekennzeichnet, dass** die Baugruppe ferner Klemmmittel (CL2) aufweist, um den flüssigkeitsgekühlten Wärmetauscher und die Wärmerohrmittel aneinander zu klemmen.

## Revendications

1. Assemblage électrique refroidi comportant un système de barres de bus comprenant au moins une première barre de bus (BB1) et une seconde barre de bus (BB2), un système de composants électriques comprenant au moins un premier composant électrique (EC1) monté entre la première barre de bus (BB1) et la seconde barre de bus (BB2), et un système de caloducs pour refroidir le système de barres de bus, le système de caloducs comprenant un caloduc (HP1, HP2, HP3) pour chaque barre de bus (BB1, BB2, BB3) du système de barres de bus, une partie d'évaporateur de chacun des caloducs (HP1, HP2, HP3) étant reliée en thermoconduction à une barre de bus correspondante (BB1, BB2, BB3), à la fois la partie d'évaporateur et une partie de condensateur de chaque caloduc (HP1, HP2, HP3) du système de caloducs étant des parties plates, l'assemblage électrique refroidi comportant en outre un système de puits de chaleur (HS) relié en thermoconduction à la partie de condensateur plate de chacun des caloducs, **caractérisé en ce qu'**une partie d'évaporateur de chacun des caloducs est électriquement isolée du système de puits de chaleur (HS) par un système d'isolation électrique, et **en ce que** le système d'isolation électrique comporte au moins une couche d'isolation plane (IL11-IL32) entre la partie de condensateur de chaque caloduc (HP1, HP2, HP3) du système de caloducs et du système de puits de chaleur (HS).

2. Assemblage électrique refroidi selon la revendication 1, **caractérisé en ce que** la connexion par thermoconduction entre une partie d'évaporateur de chaque caloduc (HP1, HP2, HP3) du système de caloducs et de la barre de bus correspondante (BB1, BB2, BB3) du système de barres de bus est une connexion intégrale prévue par exemple par brasage.

3. Assemblage électrique refroidi selon la revendication 1 ou 2, **caractérisé en ce que** chaque composant électrique (EC1, EC2) du système de composants électriques est un composant de type press-pack possédant une première borne et une seconde borne, à la fois la première borne et la seconde borne étant des bornes planaires, la première borne et la seconde borne étant situées sur des côtés opposés du composant électrique et étant parallèles l'une à l'autre.

4. Assemblage électrique refroidi selon l'une quelconque des revendications précédentes, **caractérisé en ce que** chaque barre de bus (BB1, BB2, BB3) du système de barres de bus comporte au moins une surface de borne, chacune des surfaces de borne étant reliée à une borne correspondante d'un composant électrique adjacent (EC1, EC2) et étant une surface usinée adaptée pour maximiser la thermoconduction entre la surface de la borne et la borne correspondante du composant électrique adjacent (EC1, EC2).

5. Assemblage électrique refroidi selon l'une quelconque des revendications précédentes, **caractérisé en ce que** la partie d'évaporateur de chaque caloduc (HP1) du système de caloducs comporte une structure calorifuge possédant une cavité interne (IC1) munie d'une pluralité d'éléments supports (SM) adaptés pour réduire une déformation de la cavité interne de la partie d'évaporateur induite par des forces perpendiculaires à un plan central de la partie d'évaporateur, et la partie de condensateur de chacun des caloducs comporte une structure calorifuge possédant une cavité interne munie d'une pluralité d'éléments supports adaptés pour réduire une déformation de la cavité interne de la partie de condensateur induite par des forces perpendiculaires à un plan central de la partie de condensateur.

6. Assemblage électrique refroidi selon l'une quelconque des revendications précédentes, **caractérisé en ce que** l'assemblage comporte en outre un premier système de serrage (CL1) adapté pour presser chaque composant électrique (EC1, EC2) du système de composants électriques contre une barre de bus adjacente (BB1, BB2, BB3) du système de barres de bus.

7. Assemblage électrique refroidi selon l'une quelconque des revendications précédentes, **caractérisé en ce que** chaque caloduc (HP1, HP2, HP3) du système de caloducs est un caloduc planaire de sorte qu'à la fois la partie d'évaporateur et la partie de condensateur du caloduc (HP1, HP2, HP3) sont situées sur un même plan.

8. Assemblage électrique refroidi selon l'une quelconque des revendications précédentes, **caractérisé en ce que** chaque barre de bus (BB1) du système de barres de bus est une barre de bus creuse comportant une cavité de caloduc interne (PC1), la cavité de caloduc interne (PC1) de la barre de bus (BB1) comportant au moins partiellement une partie d'évaporateur d'un caloduc correspondant (HP1).

9. Assemblage électrique refroidi selon l'une quelconque des revendications précédentes, **caractérisé en ce que** le système de barres de bus comporte en outre une troisième barre de bus (BB3), le système de composants électriques comporte en outre un second composant électrique (EC2) monté entre la seconde barre de bus (BB2) et la troisième barre de bus (BB3), le système de caloducs comprenant un premier caloduc (HP1), un second caloduc (HP2), et un troisième caloduc (HP3), une partie d'évaporateur du premier caloduc (HP1) étant reliée en thermoconduction à la première barre de bus (BB1), et la partie de condensateur du premier caloduc (HP1) étant reliée en thermoconduction au système de puits de chaleur (HS), une partie d'évaporateur du second caloduc (HP2) étant reliée en thermoconduction à la seconde barre de bus (BB2), et la partie de condensateur du second caloduc (HP2) étant reliée en thermoconduction au système de puits de chaleur (HS), une partie d'évaporateur du troisième caloduc (HP3) étant reliée en thermoconduction à la troisième barre de bus (BB3), et la partie de condensateur du troisième caloduc (HP3) étant reliée en thermoconduction au système de puits de chaleur (HS).

10. Assemblage électrique refroidi selon la revendication 9, **caractérisé en ce que** le système de puits de chaleur (HS) comporte un échangeur de chaleur refroidi par liquide possédant un premier liquide de refroidissement (CE1) et un second liquide de refroidissement (CE2), l'échangeur de chaleur refroidi par liquide étant empilé avec le système de caloducs de sorte que le premier élément de refroidissement (CE1) est serré entre le premier caloduc (HP1) et le second caloduc (HP2), et le second élément de refroidissement (CE2) est serré entre le second caloduc (HP2) et le troisième caloduc (HP3).

11. Assemblage électrique refroidi selon la revendication 10, **caractérisé en ce que** l'assemblage comporte en outre un second système de serrage (CL2) pour serrer conjointement l'échangeur de chaleur refroidi par liquide et le système de caloducs.
